# EUROPEAN PATENT APPLICATION

(11) **EP 3 029 174 A1**
(43) Date of publication of application: **08.06.2016**
(21) Application number: 14196566.5
(22) Date of filing: 05.12.2014
(51) Int. Cl.: C23C 16/455, H01L 21/02

(54) **Process for the production of porous thin films**

(71) Applicant: BASF SE, 67056 Ludwigshafen am Rhein (DE)
(72) Inventor: Ruettinger, Wolfgang, East Windsor, NJ 08520 (US); Wagloehner, Steffen, 76669 Bad Schoenborn (DE); Loeffler, Daniel, 67134 Birkenheide (DE); Adermann, Torben, 69115 Heidelberg (DE); Usui, Takane, West New York, NJ 07093 (US)
(74) Representative: BASF IP Association

(57) **Abstract**

The present invention relates to the production of porous thin films, in particular by atomic layer deposition. The present invention relates to a process for producing porous films comprising
(a) performing a sequence of depositing a compound of general formula (I) from the gaseous state on a solid substrate at a temperature below 400 °C and contacting the deposited compound of general formula (I) with a compound capable of removing A¹ from the compound of general formula (I), 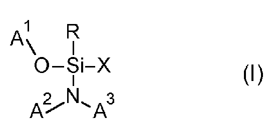 wherein
R
is an alkyl or aryl group,
X
is hydrogen, a halogen, an amine, an alkoxy group or an aryloxy group,
A¹, A², A³
are independent of each other hydrogen, alkyl groups, or aryl groups and

(b) removing R from the deposited compound of general formula (I).

## Description

The present invention is in the field of production of porous thin films, in particular by atomic layer deposition. The present invention further relates to these porous thin films.

Materials with low dielectric constant are crucial for the advancement of microchips and are used in the so-called front-end-of-line (FEOL) as well as in the back-end-of-line (BEOL) of interconnects (IC). Since the node of the IC is steadily decreasing, RC delay, cross talking and parasitic power losses of ICs are becoming a serious problem. Amorphous silica is often used as material with low dielectric constant due to its high thermal stability. The dielectric constant of silica can be decreased by introducing pores into silica films. Processes to produce such films are known from prior art.

US 2012/074 535 discloses a process for producing a dielectric material by depositing alkyldisilanes by chemical vapor despoition (CVD) or by sol-gel and subsequently removing the alkyl groups.

US 2011 / 006 406 discloses a process for producing low-k films by codeposition of silica and an organic porogen by CVD or spin-on deposition and subsequent removal of the organic porogen.

The prior art processes have the disadvantage that they do not allow a good control over the film thickness, in particular on complex-shaped substrates, and over the pore size and its distribution. The mechanical strength of films with high porosity is thus not sufficient for a variety of applications.

It was an object of the present invention to provide a process with which films of a low dielectric constant are available. It was further aimed at a process which allows a good control over the film properties, in particular the pore size and distribution. Another object was to provide a process for the production of homogeneous films on complex-shaped substrates.

These objects were achieved by a process for producing porous films comprising
(a) performing a sequence of depositing a compound of general formula (I) from the gaseous state on a solid substrate at a temperature below 400 °C and contacting the deposited compound of general formula (I) with a compound capable of removing A¹ from the compound of general formula (I), 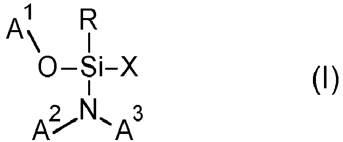 wherein
   - R: is an alkyl or aryl group,
   - X: is hydrogen, a halogen, an amine, an alkoxy group or an aryloxy group,
   - A¹, A², A³: are independent of each other hydrogen, alkyl groups, or aryl groups and
(b) removing R from the deposited compound of general formula (I).

The present invention further relates to an amorphous film on a solid substrate comprising silica having a thickness of up to 300 nm and pores with a volume average diameter of 0.1 to 4 nm wherein the standard deviation of the pore diameter is not more than 20 % of the volume average diameter.

The present invention further relates to the use of the compound of general formula (I) for the formation of amorphous porous films.

The present invention further relates to the use of the amorphous porous film according to the invention as insulator.

The present invention further relates to an electronic element comprising the film according to the invention.

Preferred embodiments of the present invention can be found in the description and the claims. Combinations of different embodiments fall within the scope of the current invention.

In the process according to the invention a compound of general formula (I) is deposited on a solid substrate. A compound can mean one compound or a mixture of several compounds. R in the compound of formula (I) is an alkyl or aryl group.

An alkyl group can be linear or branched. Examples for a linear alkyl group are methyl, ethyl, *n-*propyl, *n*-butyl, *n*-pentyl, *n*-hexyl, *n*-heptyl, *n*-octyl, *n*-nonyl, *n*-decyl. Examples for a branched alkyl group are *iso*-propyl, *iso*-butyl, *sec*-butyl, *tert-butyl,* 2-methyl-pentyl, 2-ethyl-hexyl, cyclo-propyl, cyclohexyl, indanyl, norbornyl. Preferably, the alkyl group is a C₁ to C₁₂ alkyl group, more preferably a C₂ to C₁₀ alkyl group, in particular a C₄ to C₈ alkyl group. Alkyl groups can be substituted for example by halogens like fluoride, chloride, bromide, iodide; by pseudohalogens like cyanide, cyanate, thiocyanate; by alcohols or by ethers. Unsubstituted alkyl groups are preferred.

Alternatively it is preferred that R contains a functional group which can form covalent bonds with R of another molecule of the compound of general formula (I). An example is a diene group which can react with one double bond of the diene group of a different molecule in a Diels-Alder reaction. Another example is an isocyanate group which can react with another isocyanate group, for example after it has been hydrolyzed to an amine by exposure to water. Isocyanates are preferred. It is further conceivable that different compounds of general formula (I) are used which can form covalent bonds via their R groups. For example in one compound of general formula (I) R contains can an azide and in the other compound of general formula (I) R contains an ethyne group which can form a covalent bond with each other in a dipolar addition reaction. Other examples would be acid chlorides or acid anhydrides in one compound of general formula (I) and an amine in the other. In order to avoid a reaction in the gaseous state, it is preferable to first deposit one compound of general formula (I) and later on in the process deposit the different compound of general formula (I).

Aryl groups include aromatic hydrocarbons such as phenyl, naphthalyl, anthrancenyl, phenan-threnyl groups and heteroaromatic groups such as pyrryl, furanyl, thienyl, pyridinyl, quinoyl, benzofuryl, benzothiophenyl, thienothienyl. Several of these groups or combinations of these groups are also possible like biphenyl, thienophenyl or furanylthienyl. Aryl groups can be substituted for example by halogens like fluoride, chloride, bromide, iodide; by pseudohalogens like cyanide, cyanate, thiocyanate; by alcohols; alkyl groups such as methyl or ethyl; or alkoxy groups such as methoxy or ethoxy. Aromatic hydrocarbons are preferred, phenyl is more preferred. Preferably, R contains 4 to 18 carbon atoms, in particular 4 to 8.

X in the compound of general formula (I) is hydrogen, a halogen, an amine, an alkoxy group or an aryloxygroup. Halogens include fluoride, chloride, bromide, and iodide. An amine can be an NH₂ group or an NH₂ group in which one or both hydrogens are substituted by an alkyl or an aryl group as described for R. If both hydrogens are substituted, the substituents can be the same or different to each other, preferably they are the same. Alkoxy groups are connected to the silicon atom by the oxygen atom and bear an alkyl group as described for R. Preferably, the alkyl group is a C₁ to C₁₂ alkyl group, more preferably a C₁ to C₈ alkyl group, in particular a C₁ to C₄ alkyl group, such as methyl or ethyl. Aryloxy groups are connected to the silicon atom by the oxygen atom and bear an aryl group as described for R.

A¹, A², A³ in the compound of general formula (I) are independent of each other hydrogen, alkyl groups, or aryl groups. This can mean that A¹, A², and A³ are each different to each other; or A¹ and A² are the same and A³ is different to A¹ and A²; or A¹ and A³ are the same and A² is different to A¹ and A³; or A² and A³ are the same and A¹ is different to A² and A³; or A¹, A², and A³ are the same. Preferably, A² and A³ are the same and A¹ is different to A² and A³; or all A¹, A², and A³ are the same. Alkyl and aryl groups are as described for R. Preferably, the alkyl group is a C₁ to C₁₂ alkyl group, more preferably a C₁ to C₈ alkyl group, in particular a C₁ to C₄ alkyl group, such as methyl or ethyl.

Preferably, X is an amine, an alkoxy or an aryloxy group. In this case the compound of general formula (I) is a compound of general formula (Ia) or general formula (Ib).

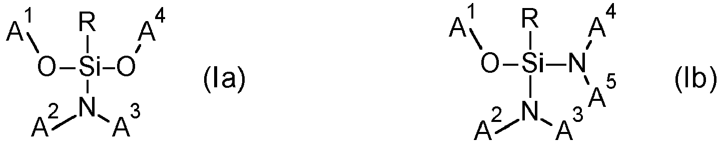

The same definitions as for A¹, A² and A³ apply for A⁴ and A⁵. In the compound of general formula (Ia) A⁴ is preferably the same as A¹. In the compound of general formula (Ib) A⁴ is preferably the same as A² and A⁵ the same as A³, more preferably A², A³, A⁴ and A⁵ are the same.

Preferably, the compound of general formula (I) has a vapor pressure of at least 1 mbar at a temperature of 80 to 300 °C, such as 1 to 100 mbar.

Some preferred examples for the compound of general formula (I) are given below.

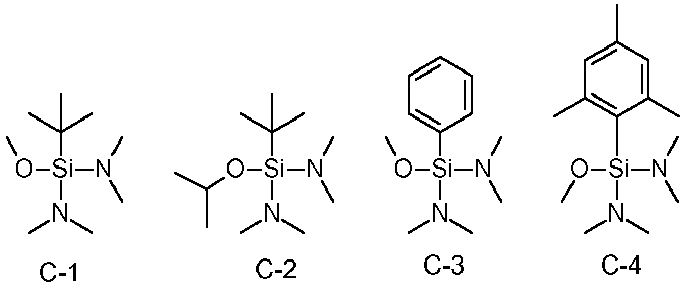

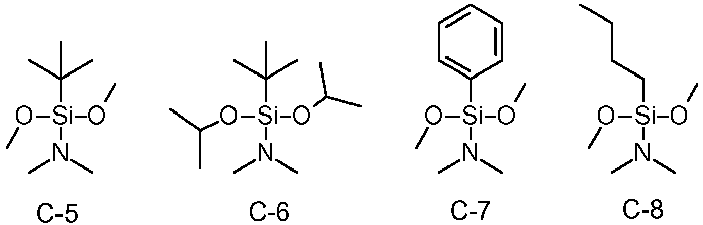

The compound of general formula (I) used in the process according to the present invention is used at high purity to achieve the best results. High purity means that the substance used contains at least 90 wt.-% compound of general formula (I), preferably at least 95 wt.-% compound of general formula (I), more preferably at least 98 wt.-% compound of general formula (I), in particular at least 99 wt.-% compound of general formula (I). The purity can be determined by elemental analysis according to DIN 51721 (Prüfung fester Brennstoffe - Bestimmung des Gehaltes an Kohlenstoff und Wasserstoff - Verfahren nach Radmacher-Hoverath, August 2001).

According to the present invention the compound of general formula (I) is deposited on a solid substrate at a temperature below 400 °C. This normally means that the solid substrate is heated to this temperature before and kept at this temperature while depositing the compound of general formula (I). The temperature is chosen such that the silicon atom forms a bond to the substrate, usually accompanied by cleavage of the Si-N bond. The O-A¹ group is normally, however retained under these conditions. Generally, the temperature at which the compound of general formula (I) is deposited on the solid substrate is -20 to 380 °C, preferably 0 to 300 °C, more preferably 25 to 250 °C, in particular 60 to 200 °C. The deposited compound of general formula (I) typically forms a more or less dense monolayer on the solid substrate, i.e. it typically covers at least 50 % of the surface of the substrate, preferably at least 70 %, in particular at least 90 %. The deposition of the compound of general formula (I) is typically self-limiting, which means that not more than a monolayer is deposited independent of how long the deposition process takes place. Usually, the deposition takes 1 ms to 1 h, preferably 100 ms to 10 min, in particular 1 s to 1 min.

A deposition process comprising a self-limiting process step and a subsequent self-limiting reaction is often referred to as atomic layer deposition (ALD). Equivalent expressions are molecular layer deposition (MLD) or atomic layer epitaxy (ALE). Hence, the process according to the present invention is preferably an ALD process. The ALD process is described in detail by George (Chemical Reviews 110 (2010), 111-131).

The compound of general formula (I) is typically a liquid or a solid at normal conditions (temperature of 25 °C and a pressure of 1013 mbar). In order to bring the compound of general formula (I) into the gaseous state it can be heated to elevated temperatures. In any case a temperature below the decomposition temperature of the compound of general formula (I) has to be chosen. Preferably, the heating temperature ranges from slightly above room temperature to 400 °C, more preferably from 30 °C to 300 °C, even more preferably from 40 °C to 250 °C, in particular from 50 °C to 200 °C.

Another way of bringing the compound of general formula (I) into the gaseous state is direct liquid injection (DLI) as described for example in US 2009 / 0 226 612 A1. In this method the compound of general formula (I) is typically dissolved in a solvent and sprayed in a carrier gas or vacuum. Various solvents can be used provided that the compound of general formula (I) shows sufficient solubility in that solvent such as at least 1 g/l, preferably at least 10 g/l, more preferably at least 100 g/l. Examples for these solvents are coordinating solvents such as tetrahydrofuran, dioxane, diethoxyethane, pyridine or non-coordinating solvents such as benzene, toluene, or xylene. Solvent mixtures are also suitable.

It is preferred to bring the compound of general formula (I) into the gaseous state at decreased pressure. In this way, usually lower heating temperatures are required leading to decreased decomposition of the compound of general formula (I). Typical pressures range from 10⁻⁶ to 1500 mbar, more preferably from 10⁻² to 100 mbar, in particular from 0.1 to 10 mbar.

In the process according to the present invention a compound of general formula (I) is deposited on a solid substrate from the gaseous state. The solid substrate can be any solid material. These include for example metals, semimetals, oxides, nitrides, and polymers. It is also possible that the substrate is a mixture of different materials. Examples for metals are aluminum, steel, zinc, and copper. Examples for semimetals are silicon, germanium, and gallium arsenide. Examples for oxides are silicon dioxide, titanium dioxide, and zinc oxide. Examples for nitrides are silicon nitride, aluminum nitride, titanium nitride, and gallium nitride. Examples for polymers are polyethylene terephthalate (PET), polyethylene naphthalene-dicarboxylic acid (PEN), and polyamides.

The solid substrate can have any shape. These include sheet plates, films, fibers, particles of various sizes, and substrates with trenches, mesopores, macropores or other indentations. The solid substrate can be of any size. If the solid substrate has a particle shape, the size of particles can range from below 100 nm to several centimeters, preferably from 1 µm to 1 mm. In order to avoid particles or fibers to stick to each other while the compound of general formula (I) is deposited onto them, it is preferably to keep them in motion. This can, for example, be achieved by stirring, by rotating drums, or by fluidized bed techniques.

The process according to the invention further comprises contacting the deposited compound of general formula (I) with a compound capable of removing A¹ from the compound of general formula (I). Compounds capable of removing A¹ from the compound of general formula (I) include oxygen, ozone, ammonia, oxidants like nitrous oxide or hydrogen peroxide, reducing agents like hydrogen, alcohols, hydrazine or hydroxylamine, or solvents like water. Exposure to water, an oxygen plasma or ozone is preferred. Exposure to water is particularly preferred. Preferably, contacting the deposited compound of general formula (I) with a compound capable of removing A¹ from the compound of general formula (I) is performed such that R remains essentially unaffected in the deposited compound of general formula (I). Essentially unaffected in the context of the present invention means that at least 50 % of the weight of R in the compound of general formula (I) is retained, preferably at least 70 %, in particular at least 90 %. It can, however happen, that a few R are removed from the compound of general formula (I) or are partially hydrolyzed.

Preferably, the sequence of depositing a compound of general formula (I) from the gaseous state on a solid substrate at a temperature below 400 °C and contacting the deposited compound of general formula (I) with a compound capable of removing A¹ from the compound of general formula (I) is repeated. The sequence is for example performed at least twice, preferably at least 20 times, in particular at least 50 times. Usually, the sequence is performed not more than 1000 times. How often the sequence is performed depends on the desired film thickness to be produced. The typical film thickness produced per sequence is from 0.01 to 1 nm, preferably from 0.02 to 0.8 nm, more preferably from 0.03 to 0.6 nm, in particular from 0.05 to 0.4 nm. The layer thickness is typically measured by ellipsometry as described in PAS 1022 DE (Referenzverfahren zur Bestimmung von optischen und dielektrischen Materialeigenschaften sowie der Schichtdicke dunner Schichten mittels Ellipsometrie; February 2004).

Preferably, the sequence of depositing a compound of general formula (I) from the gaseous state on a solid substrate at a temperature below 400 °C and contacting the deposited compound of general formula (I) with a compound capable of removing A¹ from the compound of general formula (I) further comprises depositing a silicon-comprising compound which is different to the compound of general formula (I). Such a silicon-comprising compound needs to be able to form a covalent bond with OH groups on the surface. Examples of silicon-comprising compounds include silicon halogenides such as silicon tetrachloride or silicon tetrabromide; or silanes such as monosilane, disilane, or cyclopentasilane. After deposition these compounds are preferably converted into silica, for example by a compound capable of removing A¹ from the compound of general formula (I) described above. It is either possible to deposit the silicon-containing compound together with the compound of formula (I) on the solid substrate or after the compound of general formula (I) has been contacted with a compound capable of removing A¹ from the compound of general formula (I). Preferably, the silicon-containing compound is deposited together with the compound of formula (I).

The process according to the present invention further comprises removing R from the deposited compound of general formula (I). This can preferably be done by heating to a temperature of at least 400 °C, preferably at least 450 °C, in particular at least 500 °C, and typically not more than 1000 °C depending on the substrate; irradiation with UV light such as UV light with a wavelength of 100 to 300 nm, preferably 150 to 250 nm; exposure to an oxidant such as H₂O₂, O₂ or O₃; or exposure to a plasma, such as an oxygen plasma or an argon plasma.

Preferably the process for producing porous films comprises
(A) heating a solid substrate to a temperature below 400 °C,
(B) performing at least twice a sequence of
   (B1) depositing a compound of general formula (I) and optionally a silicon-comprising compound different to the compound of formula (I) from the gaseous state on a solid substrate at a temperature below 400 °C,
   (B2) contacting the deposited compound of general formula (I) with a compound capable of removing A¹ from the compound of general formula (I), and
(C) removing R from the deposited compound of general formula (I).

Preferably, after the deposition of any substance, e.g. the compound of general formula (I), the silicon-comprising compound, or the compound capable of removing A¹ from the compound of general formula (I) any substance remaining in the gas phase is removed by either applying vacuum or by flushing an inert gas, such as nitrogen or argon, over the surface of the solid substrate.

The present invention further relates to an amorphous film on a solid substrate comprising silica having a thickness of up to 300 nm and pores with a volume average diameter of 0.1 to 4 nm wherein the standard deviation of the pore diameter is not more than 20 % of the volume average diameter.

Preferably, the amorphous film is made by the process according to the invention. The definitions and preferred embodiments described for the process apply to the amorphous film where applicable.

Amorphous in the context of the present invention means that the height of peaks in a wide-angle X-ray diffractogram of the film are not more than 10 %, preferably not more than 5 %, in particular not more than 1 % of the height of the corresponding peaks of a perfectly crystalline silica film of the same dimensions.

The thickness of the amorphous film is up to 300 nm, preferably up to 200, more preferably up to 100 nm, in particular up to 50 nm. Usually, the amorphous film has a thickness of at least 0.1 nm, preferably at least 1 nm. The film thickness can be measured by transmission electron microscopy.

The amorphous film contains pores with a volume average diameter of 0.1 to 4 nm, preferably 0.2 to 3 nm, in particular 0.3 to 2 nm, such as 0.5 to 1 nm. The standard deviation of the pore diameter is not more than 20 % of the volume average diameter, preferably not more than 15 %, in particular not more than 10 %. The pore size and pore size distribution can be measured by ellipsometric porosimetry, described for example in Microelectronic Engineering 64 (2002) 335-349.

Preferably, the porosity of the amorphous film is at least 20 %, more preferably at least 30 %, in particular at least 40 %.

Preferably, the amorphous film is conformal on the solid substrate which means that the surface profile of the amorphous film is essentially the same at that of the solid substrate.

The amorphous film according to the present invention has a high mechanical strength in comparison to amorphous films from prior art as they are free of any grain boundaries.

The amorphous film according to the present invention has a low dielectric constant. The dielectric constant is typically 1.5 to 3.0, preferably 1.8 to 2.5. Therefore, the amorphous film can be used as insulator, in particular in electronic elements. The electronic elements can have structural features of various sizes, for example from 10 nm to 100 µm. The process for forming the amorphous films for the electronic elements is particularly well suited for very fine structures. Therefore, electronic elements with sizes below 1 µm are preferred. Examples for electronic elements are field-effect transistors (FET), solar cells, light emitting diodes, sensors, or capacitors. Transistors are preferred electronic elements.

## Claims

1. A process for producing porous films comprising
(a) performing a sequence of depositing a compound of general formula (I) from the gaseous state on a solid substrate at a temperature below 400 °C and contacting the deposited compound of general formula (I) with a compound capable of removing A¹ from the compound of general formula (I), 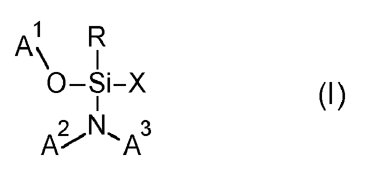 wherein
R is an alkyl or aryl group,
X is hydrogen, a halogen, an amine, an alkoxy group or an aryloxy group,
A¹, A², A³ are independent of each other hydrogen, alkyl groups, or aryl groups and
(b) removing R from the deposited compound of general formula (I).

2. The process according to claim 1 wherein the sequence of depositing a compound of general formula (I) on a solid substrate and contacting the deposited compound of general formula (I) with a compound capable of removing A¹ from the compound of general formula (I) is performed at least 20 times.

3. The process according to claim 1 or 2 wherein the compound capable of removing A¹ from the compound of general formula (I) is water.

4. The process according to any of the claims 1 to 3 wherein R in the compound of general formula (I) contains 4 to 8 carbon atoms.

5. The process according to any of the claims 1 to 4 wherein X in the compound of general formula (I) is an amine group.

6. An amorphous film on a solid substrate comprising silica having a thickness of up to 300 nm and pores with a volume average diameter of 0.1 to 4 nm wherein the standard deviation of the pore diameter is not more than 20 % of the volume average diameter.

7. The film according to claim 6 wherein the porosity of the amorphous film is at least 20 %.

8. The film according to claim 6 or 7 wherein the amorphous film is conformal on the solid substrate.

9. The film according to any of the claims 6 to 8 wherein the solid substrate comprises silicon.

10. Use of the compound of general formula (I) for the formation of amorphous porous films.

11. Use of the film according to any of the claims 6 to 8 as insulator.

12. An electronic element comprising the film according to any of the claims 6 to 8.

13. The electronic element according to claim 12 where in the electronic element is a transistor.
